# EUROPEAN PATENT SPECIFICATION

(11) **EP 4 445 700 B1**
(45) Date of publication and mention of the grant of the patent: **12.08.2026**
(21) Application number: 22830495.2
(22) Date of filing: 06.12.2022
(51) Int. Cl.: H05K 7/20

(54) **HOUSING FOR AN ELECTRONIC CIRCUIT**
GEHÄUSE FÜR EINE ELEKTRONISCHE SCHALTUNG
BOÎTIER POUR UN CIRCUIT ÉLECTRONIQUE

(30) Priority: 10.12.2021 DE 102021132731
(43) Date of publication of application: 16.10.2024
(73) Proprietor: Connaught Electronics Ltd., Tuam, County Galway (IE)
(72) Inventor: BOGIEL, Justyna, Tuam, (IE); GIBBONS, Stephen, Tuam, (IE)
(74) Representative: Jauregui Urbahn, Kristian
(86) International application number: PCT/EP2022/084502
(87) International publication number: WO 2023/104760

(56) References cited:
- DE-A1- 102017 002 665
- DE-B4- 102011 113 929
- DE-T5- 112013 007 178

## Description

The present invention is directed to a housing for at least one electronic circuit, the housing comprising a housing portion with an inner surface. The invention is further directed to an electronic device with a housing, to a motor vehicle with an electronic device and for a method for manufacturing an electronic device.

Electronic devices comprise electronic circuits and components, which may generate significant amounts of heat. In order to ensure a proper function of the components and the circuit and in order to extend the lifetime of the component or the circuit, the heat may be transported away from the heat generating electronic component.

In particular, in the automotive context that is for an electronic device designed to be used in motor vehicles the heat dissipation rate is an important factor. If the heat dissipation rate achieved by means of passive cooling is not sufficient, active cooling devices may have to be installed, which is not desirable from a cost perspective and from a perspective of overall complexity.

It is known, for example, to connect a heat generating electronic component of an electronic device to a housing of the device by means of a thermal paste. One drawback of this approach is that the rate of heat dissipation from the electronic component via the thermal paste and the housing to the environment of the housing is more or less restricted by the size of the housing portion located directly above the heat generating component.

In DE102017002665A1 is described a housing part for a camera housing, particularly for use in the automobile sector. It consists of an outer-side housing shell made of a synthetic material and an inner-side housing shell made of a more heat-conductive material. The two shells are directly connected to each other across all opposite-lying surface regions.

In DE112013007178 is disclosed a thermal conduction method utilizing a flat, strip-shaped graphite foil heat conductor. This heat conductor comprises a heat conduction component, to one end of which a thermal contact component is attached. The thermal contact component is positioned between a heat source and a radiator, ensuring direct contact between its surface and the surfaces of both the heat source and the radiator. In DE102011113929A an electrical component is disclosed that is placed in thermally conductive contact with a thermally conductive, electrically oversized conductor structure in the form of a stamped grid for large-area spreading of heat loss to be dissipated from an electrical component.

It is an objective of the present invention to provide a housing for at least one electronic circuit, which allows for an increased heat dissipation rate of heat generated by an electronic component of the at least one electronic circuit.

This objective is achieved by the respective subject-matter of the independent claims.

Further implementations and preferred embodiments are subject-matter of the dependent claims.

The invention is based on the idea to place a heat spreader component on an inner surface of the housing, which can be connected to the electronic component. By choosing the material of the heat spreader component such that its thermal conductivity is greater than the thermal conductivity of the housing portion, a lateral spread of the dissipated heat is achieved, which leads to a faster transport of the heat away from the location where it is generated by the electronic component.

According to an aspect of the invention, a housing for at least one electronic circuit is provided. The housing comprises a housing portion with an inner surface, and the housing comprises a heat spreader component, which is connected to the inner surface of the housing portion. The heat spreader component comprises a contact region to be connected to an electronic component of the at least one electronic circuit. The heat spreader component comprises, in particular consists of, a material, whose thermal conductivity is greater than a thermal conductivity of the housing portion, in particular a material of the housing portion.

The housing and the at least one electronic circuit may, for example, be considered as respective parts of an electronic device, in particular an electronic device of a motor vehicle or for a motor vehicle.

When the electronic device is assembled, the housing may form an enclosure, in which the at least one electronic circuit is arranged. The at least one electronic circuit may comprise a circuit board and the electronic component may be mounted on the circuit board such that it faces the inner surface of the housing portion. The electronic component is then, in the assembled state, connected to the heat spreader component. In other words, the heat spreader component is arranged between the housing portion and the electronic component and is connected and in thermal contact to both of them.

The heat spreader component may be connected to the housing portion, for example, by means of an adhesive and/or mechanical fasteners. In particular, the connection is such that a heat transfer may occur from the heat spreader component to the housing portion.

Consequently, the heat generated by the electronic component is transferred at least in part to the heat spreader component. From the heat spreader component, a part of the heat may be transferred directly to the housing portion above the contact region. However, another part of the heat may be spread in lateral direction within the heat spreader component. Therein, a lateral direction may be understood as a direction parallel to the inner surface or a surface of the electronic component, which is connected to the heat spreader component. A normal direction is perpendicular to the inner surface or the surface of the electronic component or the lateral directions, respectively.

In particular, apart from the contact region, the heat spreader component has a further region, for example a heat transfer region surrounding the contact region laterally, in particular completely or in part. Therefore, the heat flow is not forced essentially into the normal direction but also may spread laterally to a significant amount. This is, in particular, achieved by selecting the thermal conductivity of the heat spreader component material greater than the thermal conductivity of the material of the housing portion. If the thermal conductivity of the heat spreader component would be smaller than the thermal conductivity of the housing portion, the heat would flow essentially in the normal direction but would not be spread laterally in a significant amount. Therefore, the material of the housing portion and the heat spreader component directly above the electronic component would restrict the rate of heat transfer. According to the invention, however, a significant amount of lateral spread of heat by the heat spreader component is achieved by selecting the thermal conductivity of its material as explained.

In this way, the heat generated by the electronic component is distributed or transferred to other regions of the housing portion. By adapting the geometric shape of the heat spreader component according to the electronic circuit, it may therefore be achieved that the heat is transferred from the heat generating electronic component towards regions above the at least one electronic circuit, where less heat is generated. In other words, potentially cooler regions in the interior of the housing may be exploited as effective heat sinks by distributing the heat from the hotter regions via the heat spreader component.

In this way, an overall increased heat dissipation rate may be achieved, and more costly or complex solutions for active cooling may be avoided or may only be necessary to a smaller extent. This is particularly beneficial in the context of automotive electronic devices, where even small improvements in the heat dissipation rate of electronic devices may allow for omitting an active cooling system.

According to several implementations, the heat spreader component is formed as an essentially two-dimensional layer.

The layer may be solid or may comprise a grid structure that is an essentially periodic lattice or an irregular mesh. In some implementations, solid regions as well as grid regions may be combined together. For example, the contact region may be solid and the heat transfer region may be formed as a grid structure in some implementations. However, also other combinations may be possible. In other implementations, the whole heat spreader component may be formed as a solid layer or as a grid layer.

That the heat spreader component is an essentially two-dimensional layer may be understood such that a uniform thickness of the heat spreader component in the normal direction is much smaller than an extension in the lateral directions, in particular the maximum lateral extensions. For example, the thickness of the heat spreader component may be 2 mm or less, preferably 1 mm or less. An extension in the lateral directions or, in other words a width and/or a length dimension of the heat spreader component, may for example be at least 10 times the thickness, in particular at least 20 times the thickness, for example, at least 50 times the thickness.

According to several implementations, the heat spreader component comprises the heat transfer region surrounding the contact region at least in part, in particular laterally.

The heat transfer region is not in contact with the electronic component. For example, the electronic component may be connected to the heat spreader component only in the contact region.

In this way, the heat generated by the electronic component is transferred to the contact region of the heat spreader component and from there is transported laterally via the heat transfer region as well as directly to the housing portion. Furthermore, the heat may then also be transferred from the heat transfer region to the housing portion.

According to the invention, the heat spreader component, in particular, the essentially two-dimensional layer, comprises a grid structure made of the material.

In particular, the heat spreader component is formed as an essentially two-dimensional layer comprising or consisting of the grid structure. The grid structure may be considered as a plurality of spaced and/or crossing strips of the material. The strips may form a periodic or essentially periodic lattice or an irregular mesh.

By designing the heat spreader component to comprise the grid structure, the lateral heat transfer rate may be further increased. The total heat capacity of the heat spreader component might be reduced by the grid structure. However, it is the heat transfer rate, which is most relevant for these implementations of the housing. On the other hand, the reduced total heat capacity may be increased by increasing the lateral extension of the heat spreader component, if this is desired.

According to several implementations, the thermal conductivity of the material of the heat spreader component is equal to or greater than 270 W/(m*K). Preferably, the thermal conductivity of the material is equal to or greater than 290 W/(m*K).

If not stated otherwise, values of the thermal conductivity mentioned here and in the following may be understood as values at normal conditions that is at a normal temperature of 20 °C and a normal air pressure of 1000 hPa.

For example, the material comprises or consists of copper and/or gold and/or silver.

Preferably, the material comprises or consists of either copper or gold or silver.

Copper has a thermal conductivity of approximately 386 W/(m*K), gold has a thermal conductivity of approximately 310 W/(m*K) and silver has a thermal conductivity of approximately 419 W/(m*K).

On the other hand, the thermal conductivity of the housing portion or the material of the housing portion is equal to or smaller than 250 W/(m*K). Preferably, it is equal to or smaller than 220 W/(m*K).

For example, the housing portion comprises or consists of aluminum, in particular, cast aluminum and/or magnesium and/or steel and/or a plastic material. Preferably, the housing portion comprises or consists of either aluminum or magnesium or steel or plastic.

Aluminum has a thermal conductivity of approximately 239 W/(m*K), magnesium has a thermal conductivity of approximately 151 W/(m*K), and steel may for example have a thermal conductivity of 50 W/(m*K) or less depending on the specific alloy. Plastic materials usually have a thermal conductivity of less than 1 W/(m*K).

In particular, the thermal conductivity of the material may be equal to or greater than 270 W/(m*K) and smaller than 600 W/(m*K). On the other hand, in some implementations, the thermal conductivity of the housing portion may be equal to or smaller than 250 W/(m*K) and greater than 0.05 W/(m*K).

It is noted that, however, in any case, the materials used for the heat spreader component and the housing portion, respectively, differ in their thermal conductivity such that the thermal conductivity of the material of the heat spreader component is greater than the thermal conductivity of the material of the housing portion.

According to several implementations, the housing comprises an adhesive material arranged between the heat spreader component and the inner surface of the housing portion, wherein the adhesive material connects the heat spreader component to the inner surface of the housing portion.

In other words, the heat spreader component is connected to the inner surface by means of the adhesive material.

Alternatively or in addition, the housing comprises at least one mechanical fastener, which connects the heat spreader component to the inner surface of the housing portion.

According to a further aspect of the invention, an electronic device comprising at least one electronic circuit is provided. The at least one electronic circuit comprises an electronic component, and the electronic device comprises a housing according to the invention for the at least one electronic circuit. The heat spreader component is connected to the electronic component at, in or via the contact region.

According to several implementations of the electronic device, the electronic device comprises a thermal paste connecting the heat spreader component to the electronic component at the contact region.

In this way, the heat dissipation rate may be further improved, and the flow of the heat from the electronic device to the heat spreader component may be directed accordingly.

According to several implementations, the electronic device is designed for use in or on a motor vehicle. For example, the electronic device may be an electronic control unit, ECU, of the motor vehicle or a part of a sensor system of the motor vehicle, for example, an automotive camera.

According to a further aspect of the invention, a motor vehicle comprising an electronic device according to the invention is provided.

According to a further aspect of the invention, a method for manufacturing an electronic device is provided. The method comprises providing at least one electronic circuit for the electronic device and providing a housing with a housing portion, which has an inner surface. Furthermore, a heat spreader component, which comprises a material, whose thermal conductivity is greater than a thermal conductivity of the housing portion, is provided. The heat spreader component is connected to the inner surface of the housing portion and a contact region of the heat spreader component is connected to an electronic component of the at least one electronic circuit.

According to several implementations of the method, the heat spreader component is connected to the inner surface of the housing portion by means of an adhesive material and/or by means of at least one mechanical fastener.

According to several implementations, the contact region is connected to the electronic component by means of thermal paste.

Further implementations of the method for manufacturing an electronic device according to the invention follow directly from the various implementations of the housing according to the invention and the electronic device according to the invention and vice versa, respectively. In particular, an electronic device according to the invention may be manufactured by means of a method according to the invention.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, are also comprised by the invention. Moreover, embodiments and combinations of features which go beyond or deviate from the combinations of features set forth in the recitations of the claims are comprised by the invention.

In the figures,
- Fig. 1: shows a schematic cross-sectional view of an exemplary implementation of an electronic device according to the invention;
- Fig. 2: shows a schematic cross-sectional view of a part of the electronic device of Fig. 1;
- Fig. 3: shows a schematic top view of a part of a further exemplary implementation of an electronic device according to the invention;
- Fig. 4: shows a schematic top view of a part of a further exemplary implementation of an electronic device according to the invention;
- Fig. 5: shows a schematic top view of a further exemplary implementation of an electronic device according to the invention; and
- Fig. 6: shows schematically an exemplary implementation of a motor vehicle according to the invention.

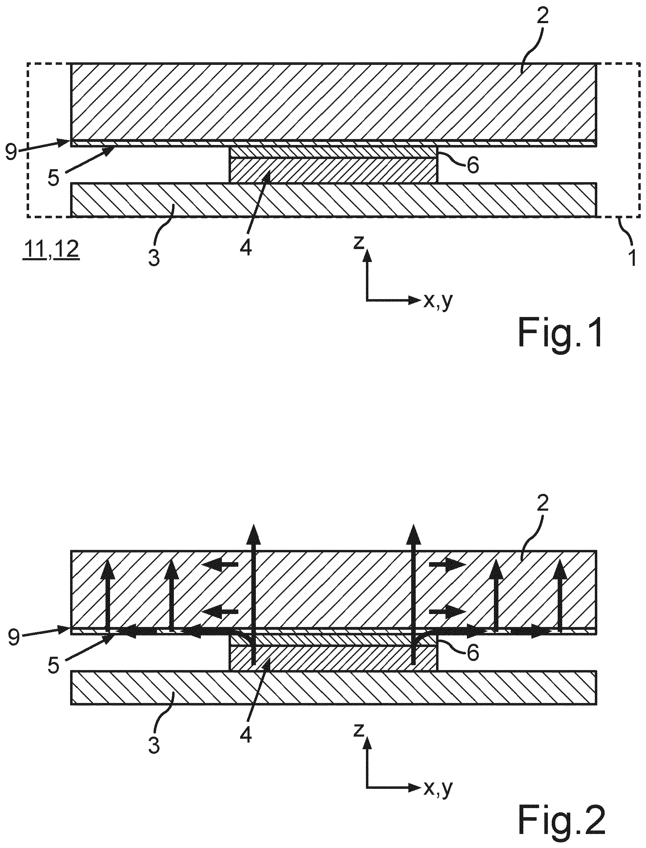

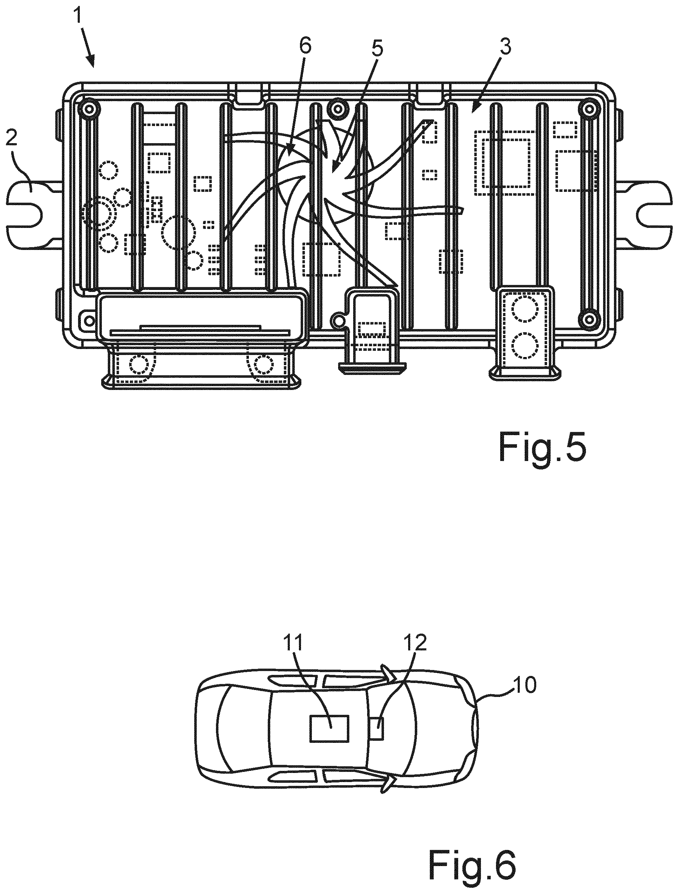

Fig. 1 shows a schematic sectional view of an exemplary implementation of an electronic device 11, 12, which may for example be designed as an ECU 11 or an automotive camera 12 or another component of a motor vehicle 10, as indicated in Fig. 6.

The electronic device 11, 12 comprises a housing 1 and an electronic circuit, which contains a circuit board 3 and an electronic component 4 mounted on top of the circuit board 3. The circuit board 3 may for example extend in an x-y-plane, which may also be denoted as lateral plane or lateral directions. A normal direction perpendicular to the surface of the circuit board 3 may be denoted as a z-direction.

The housing 1 comprises a housing portion 2 with an inner surface 9, which is at least approximately parallel to the x-y-plane. Furthermore, the housing 1 comprises heat spreader component 5, which is designed as an essentially two-dimensional layer and connected to the inner surface 9 of the housing portion 2. In a contact region, the heat spreader component 5 is thermally connected to the electronic component 4, for example, by means of a thermal paste 6.

The heat spreader component 5 is made of a material, whose thermal conductivity is greater than the thermal conductivity of the housing portion 2. For example, the housing portion 2 may be made of cast aluminum, while the heat spreader component may be made of gold or copper.

Fig. 2 shows a part of the electronic device 11, 12 of Fig. 1, namely the housing portion 2, the heat spreader component 5, the circuit board 3 and the electronic component 4. Furthermore, a plurality of arrows in Fig. 2 indicates schematically a heat flow of heat generated by the electronic component 4.

If the heat spreader component 5 would not be present, the thermal paste 6 would directly connect the electronic component 4 to the housing portion 2. Consequently, heat transfer would be limited to the size of the thermal paste 6 itself. Therefore, the heat would move only or essentially in z-direction. In case the housing portion 2 directly above the hot electronic component 4 is not able to dissipate heat fast enough, the generated heat may accumulate and move only very slowly outwards in lateral direction.

By providing the heat spreader component 5 between the thermal paste 6 and the housing portion 2, the heat is allowed to disperse across the full size of the heat spreader component 5 in lateral directions. The heat spreader component 5 is contact with the housing portion 2 over its full surface area such that the heat may be transferred to the housing portion 2 more effectively. In particular, the heat generated by the electronic component 4 is transferred to the heat spreader component 5 via the thermal paste 6 and then moves along the z-direction as well as along the lateral directions in the x-y-plane. In this case, if the housing portion 2 directly above the electronic component 4 is not able to dissipate the heat fast enough, the heat can still be transported away from the electronic component 4 laterally via the heat spreader component 5.

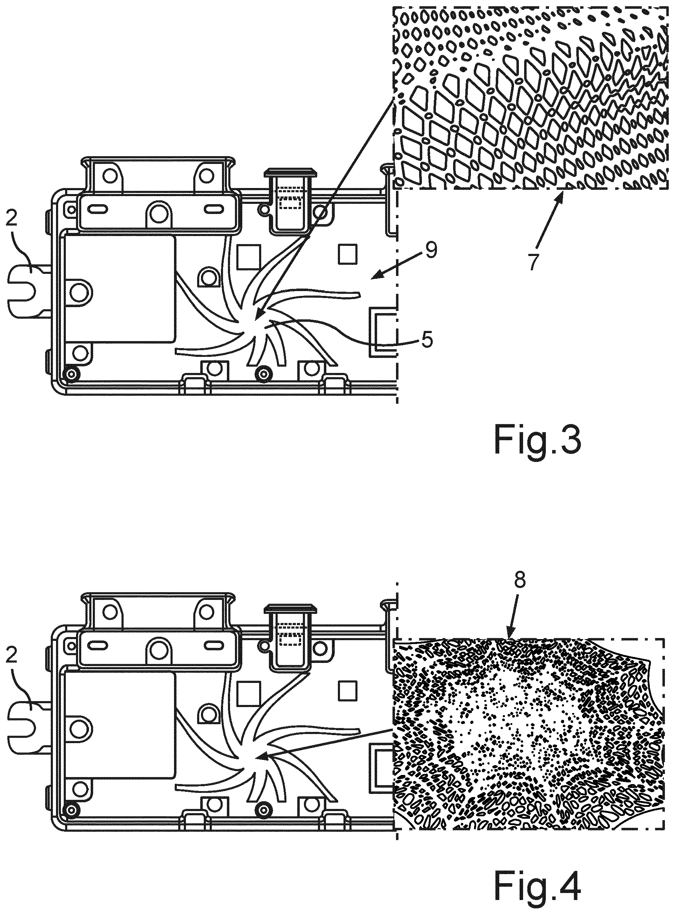

Fig. 3 shows a schematic representation of the housing portion 2 and the heat spreader component 5 on the inner surface 9 for a further exemplary implementation according to the invention.

Here, the heat spreader component 5 has, for example, a star-like geometric shape having an inner contact region for connecting the electronic component 4 and a plurality of arms extending from the inner contact region to allow for a heat transfer at an increased heat transfer rate.

In some implementations, the heat spreader component 5 may consist of a regular lattice structure 7, as indicated in the inset of Fig. 3. In other implementations, the heat spreader component 5 may consist of an irregular mesh structure 8 as shown schematically in Fig. 4 and the corresponding inset.

By choosing such regular lattice structures or irregular mesh structures, a particularly large heat dissipation rate may be achieved whilst providing least thermal resistance and reducing the total amount of material of the heat spreader component 5, which in turn reduces its costs.

Fig. 5 shows schematically an exemplary implementation of the device 11, 12 as shown with respect to Fig. 3 or Fig. 4 in an assembled state. The housing portion 2 is shown essentially transparent to make the electronic circuit and the heat spreader component 5 visible.

As described, in particular with respect to the figures, the invention achieves an increased heat dissipation rate in an electronic device by providing a heat spreader component fixed to the inside of a housing portion. In some implementations, a thermal pedestal feature may be used in conjunction with the heat spreader component.

By means of the heat spreader component, the thermal distribution of electronic components on the circuit board generating large amount of heat is improved without affecting the function of surrounding parts negatively.

## Claims

1. Housing (1) for at least one electronic circuit (3, 4), the housing (1) comprising a housing portion (2) with an inner surface (9),
- the housing (1) comprises a heat spreader component (5), which is connected to the inner surface (9) of the housing portion (2);
- the heat spreader component (5) comprises a contact region to be connected to an electronic component (4) of the at least one electronic circuit (3, 4);
- the heat spreader component (5) comprises a material, whose thermal conductivity is greater than a thermal conductivity of the housing portion (2);
- the heat spreader component (5) has a star-like geometric shape having an inner contact region for connecting the electronic component (4) and a plurality of arms extending from the inner contact region to allow for a heat transfer at an increased heat transfer rate, and
- the heat spreader component (5) comprises a grid structure (7, 8) made of the material.

2. Housing (1) according to claim 1,
**characterized in that**
the heat spreader component (5) is formed as an essentially two-dimensional layer.

3. Housing (1) according to one of the preceding claims,
**characterized in that**
the heat spreader component (5) comprises a heat transfer region surrounding the contact region at least in part.

4. Housing (1) according to one of the preceding claims,
**characterized in that**
- the thermal conductivity of the material is equal to or greater than 270 W/(m*K);
and/or
- the thermal conductivity of the housing portion (2) is equal to or smaller than 250 W/(m*K).

5. Housing (1) according to one of claims 1 to3,
**characterized in that**
- the material comprises copper and/or gold and/or silver; and/or
- the housing portion (2) comprises aluminum and/or magnesium and/or steel and/or a plastic material.

6. Housing (1) according to one of the preceding claims,
**characterized in that**
- the housing (1) comprises an adhesive material arranged between the heat spreader component (5) and the inner surface (9) of the housing portion (2), the adhesive material connecting the heat spreader component (5) to the inner surface (9) of the housing portion (2); and/or
- the housing (1) comprises at least one mechanical fastener, which connects the heat spreader component (5) to the inner surface (9) of the housing portion (2).

7. Electronic device (11, 12) comprising at least one electronic circuit (3, 4), which comprises an electronic component (4), and a housing (1) for the at least one electronic circuit (3, 4),
**characterized in that**
the housing (1) is designed according to one of the preceding claims, wherein the heat spreader component (5) is connected to the electronic component (4) at the contact region.

8. Electronic device (11, 12) according to claim 7,
**characterized in that**
the electronic device (11, 12) comprises a thermal paste (6) connecting the heat spreader component (5) to the electronic component (4) at the contact region.

9. Electronic device (11, 12) according to one of claims 7 or 8,
**characterized in that**
the electronic device (11, 12) is designed for use in or on a motor vehicle (10).

10. Electronic device (11, 12) according to claim 9,
**characterized in that**
the electronic device (11, 12) is an electronic control unit of the motor vehicle (10).

11. Electronic device (11, 12) according to claim 9,
**characterized in that**
the electronic device (11, 12) is part of a sensor system of the motor vehicle (10), in particular, the electronic device (11, 12) is an automotive camera.

12. Motor vehicle (10) comprising an electronic device (11, 12) according to one of claims 7 to 11.

13. Method for manufacturing an electronic device (11, 12), wherein the method comprises providing at least one electronic circuit (3, 4) for the electronic device (11, 12) and providing a housing (1) with a housing portion (2), which has an inner surface (9),
- a heat spreader component (5) is provided and connected to the inner surface (9) of the housing portion (2), wherein the heat spreader component (5) comprises a material, whose thermal conductivity is greater than a thermal conductivity of the housing portion (2);
- a contact region of the heat spreader component (5) is connected to an electronic component (4) of the at least one electronic circuit (3, 4), and
- the heat spreader component (5) is made from a grid structure (7, 8) material.

14. Method according to claim 13,
**characterized in that**
- the heat spreader component (5) is connected to the inner surface (9) of the housing portion (2) by means of an adhesive material and/or by means of at least one mechanical fastener; and/or
- the contact region is connected to the electronic component (4) by means of a thermal paste (6).

## Patentansprüche

1. Gehäuse (1) für mindestens eine elektronische Schaltung (3, 4), wobei das Gehäuse (1) einen Gehäuseteil (2) mit einer Innenfläche (9) umfasst,
- das Gehäuse (1) umfasst eine Wärmeverteilerkomponente (5), die mit der Innenfläche (9) des Gehäuseteils (2) verbunden ist;
- die Wärmeverteilerkomponente (5) umfasst einen Kontaktbereich, der mit einer elektronischen Komponente (4) der mindestens einen elektronischen Schaltung (3, 4) zu verbinden ist;
- die Wärmeverteilerkomponente (5) umfasst ein Material, dessen Wärmeleitfähigkeit größer ist als eine Wärmeleitfähigkeit des Gehäuseteils (2);
- die Wärmeverteilerkomponente (5) hat eine sternartige geometrische Form mit einem inneren Kontaktbereich zum Verbinden der elektronischen Komponente (4) und einer Vielzahl von Armen, die sich vom inneren Kontaktbereich erstrecken, um eine Wärmeübertragung mit einer erhöhten Wärmeübertragungsrate zu ermöglichen, und
- die Wärmeverteilerkomponente (5) umfasst eine Gitterstruktur (7, 8) aus dem Material.

2. Gehäuse (1) nach Anspruch 1,
**dadurch gekennzeichnet, dass**
die Wärmeverteilerkomponente (5) als eine im Wesentlichen zweidimensionale Schicht ausgebildet ist.

3. Gehäuse (1) nach einem der vorhergehenden Ansprüche,
**dadurch gekennzeichnet, dass**
die Wärmeverteilerkomponente (5) einen Wärmeübertragungsbereich umfasst, der den Kontaktbereich zumindest teilweise umgibt.

4. Gehäuse (1) nach einem der vorhergehenden Ansprüche,
**dadurch gekennzeichnet, dass**
- die Wärmeleitfähigkeit des Materials gleich oder größer als 270 W/(m*K) ist; und/oder
- die Wärmeleitfähigkeit des Gehäuseteils (2) gleich oder kleiner als 250 W/(m*K) ist.

5. Gehäuse (1) nach einem der Ansprüche 1 bis 3,
**dadurch gekennzeichnet, dass**
- das Material Kupfer und/oder Gold und/oder Silber umfasst; und/oder
- der Gehäuseteil (2) Aluminium und/oder Magnesium und/oder Stahl und/oder ein Kunststoffmaterial umfasst.

6. Gehäuse (1) nach einem der vorhergehenden Ansprüche,
**dadurch gekennzeichnet, dass**
- das Gehäuse (1) ein Klebematerial umfasst, das zwischen der Wärmeverteilerkomponente (5) und der Innenfläche (9) des Gehäuseteils (2) angeordnet ist, wobei das Klebematerial die Wärmeverteilerkomponente (5) mit der Innenfläche (9) des Gehäuseteils (2) verbindet; und/oder
- das Gehäuse (1) mindestens ein mechanisches Befestigungselement umfasst, das die Wärmeverteilerkomponente (5) mit der Innenfläche (9) des Gehäuseteils (2) verbindet.

7. Elektronisches Gerät (11, 12), umfassend mindestens eine elektronische Schaltung (3, 4), die eine elektronische Komponente (4) umfasst, und ein Gehäuse (1) für die mindestens eine elektronische Schaltung (3, 4),
**dadurch gekennzeichnet, dass**
das Gehäuse (1) nach einem der vorhergehenden Ansprüche ausgebildet ist, wobei die Wärmeverteilerkomponente (5) mit der elektronischen Komponente (4) am Kontaktbereich verbunden ist.

8. Elektronisches Gerät (11, 12) nach Anspruch 7,
**dadurch gekennzeichnet, dass**
das elektronische Gerät (11, 12) eine Wärmeleitpaste (6) umfasst, die die Wärmeverteilerkomponente (5) mit der elektronischen Komponente (4) am Kontaktbereich verbindet.

9. Elektronisches Gerät (11, 12) nach einem der Ansprüche 7 oder 8,
**dadurch gekennzeichnet, dass**
das elektronische Gerät (11, 12) für die Verwendung in oder an einem Kraftfahrzeug (10) ausgelegt ist.

10. Elektronisches Gerät (11, 12) nach Anspruch 9,
**dadurch gekennzeichnet, dass**
das elektronische Gerät (11, 12) ein elektronisches Steuergerät des Kraftfahrzeugs (10) ist.

11. Elektronisches Gerät (11, 12) nach Anspruch 9,
**dadurch gekennzeichnet, dass**
das elektronische Gerät (11, 12) Teil eines Sensorsystems des Kraftfahrzeugs (10) ist, insbesondere ist das elektronische Gerät (11, 12) eine Fahrzeugkamera.

12. Kraftfahrzeug (10), umfassend ein elektronisches Gerät (11, 12) nach einem der Ansprüche 7 bis 11.

13. Verfahren zur Herstellung eines elektronischen Geräts (11, 12), wobei das Verfahren das Bereitstellen mindestens einer elektronischen Schaltung (3, 4) für das elektronische Gerät (11, 12) und das Bereitstellen eines Gehäuses (1) mit einem Gehäuseteil (2), der eine Innenfläche (9) aufweist, umfasst,
- eine Wärmeverteilerkomponente (5) wird bereitgestellt und mit der Innenfläche (9) des Gehäuseteils (2) verbunden, wobei die Wärmeverteilerkomponente (5) ein Material umfasst, dessen Wärmeleitfähigkeit größer ist als eine Wärmeleitfähigkeit des Gehäuseteils (2);
- ein Kontaktbereich der Wärmeverteilerkomponente (5) wird mit einer elektronischen Komponente (4) der mindestens einen elektronischen Schaltung (3, 4) verbunden, und
- die Wärmeverteilerkomponente (5) wird aus einem Gitterstruktur (7, 8) Material hergestellt.

14. Verfahren nach Anspruch 13,
**dadurch gekennzeichnet, dass**
- die Wärmeverteilerkomponente (5) mit der Innenfläche (9) des Gehäuseteils (2) mittels eines Klebematerials und/oder mittels mindestens eines mechanischen Befestigungselements verbunden wird; und/oder
- der Kontaktbereich mit der elektronischen Komponente (4) mittels einer Wärmeleitpaste (6) verbunden wird.

## Revendications

1. Boîtier (1) pour au moins un circuit électronique (3, 4), le boîtier (1) comprenant une partie de boîtier (2) avec une surface intérieure (9),
- le boîtier (1) comprend un composant dissipateur de chaleur (5), qui est connecté à la surface intérieure (9) de la partie de boîtier (2) ;
- le composant dissipateur de chaleur (5) comprend une région de contact destinée à être connectée à un composant électronique (4) du au moins un circuit électronique (3, 4) ;
- le composant dissipateur de chaleur (5) comprend un matériau dont la conductivité thermique est supérieure à une conductivité thermique de la partie de boîtier (2) ;
- le composant dissipateur de chaleur (5) a une forme géométrique en étoile ayant une région de contact intérieure pour connecter le composant électronique (4) et une pluralité de bras s'étendant depuis la région de contact intérieure pour permettre un transfert de chaleur à un taux de transfert de chaleur accru, et
- le composant dissipateur de chaleur (5) comprend une structure en grille (7, 8) faite du matériau.

2. Boîtier (1) selon la revendication 1,
**caractérisé en ce que**
le composant dissipateur de chaleur (5) est formé comme une couche essentiellement bidimensionnelle.

3. Boîtier (1) selon l'une des revendications précédentes,
**caractérisé en ce que**
le composant dissipateur de chaleur (5) comprend une région de transfert de chaleur entourant au moins en partie la région de contact.

4. Boîtier (1) selon l'une des revendications précédentes,
**caractérisé en ce que**
- la conductivité thermique du matériau est égale ou supérieure à 270 W/(m*K) ; et/ou
- la conductivité thermique de la partie de boîtier (2) est égale ou inférieure à 250 W/(m*K).

5. Boîtier (1) selon l'une des revendications 1 à 3,
**caractérisé en ce que**
- le matériau comprend du cuivre et/ou de l'or et/ou de l'argent ; et/ou
- la partie de boîtier (2) comprend de l'aluminium et/ou du magnésium et/ou de l'acier et/ou un matériau plastique.

6. Boîtier (1) selon l'une des revendications précédentes,
**caractérisé en ce que**
- le boîtier (1) comprend un matériau adhésif disposé entre le composant dissipateur de chaleur (5) et la surface intérieure (9) de la partie de boîtier (2), le matériau adhésif connectant le composant dissipateur de chaleur (5) à la surface intérieure (9) de la partie de boîtier (2) ; et/ou
- le boîtier (1) comprend au moins une fixation mécanique, qui connecte le composant dissipateur de chaleur (5) à la surface intérieure (9) de la partie de boîtier (2).

7. Dispositif électronique (11, 12) comprenant au moins un circuit électronique (3, 4), qui comprend un composant électronique (4), et un boîtier (1) pour le au moins un circuit électronique (3, 4),
**caractérisé en ce que**
le boîtier (1) est conçu selon l'une des revendications précédentes, dans lequel le composant dissipateur de chaleur (5) est connecté au composant électronique (4) au niveau de la région de contact.

8. Dispositif électronique (11, 12) selon la revendication 7,
**caractérisé en ce que**
le dispositif électronique (11, 12) comprend une pâte thermique (6) connectant le composant dissipateur de chaleur (5) au composant électronique (4) au niveau de la région de contact.

9. Dispositif électronique (11, 12) selon l'une des revendications 7 ou 8,
**caractérisé en ce que**
le dispositif électronique (11, 12) est conçu pour une utilisation dans ou sur un véhicule à moteur (10).

10. Dispositif électronique (11, 12) selon la revendication 9,
**caractérisé en ce que**
le dispositif électronique (11, 12) est une unité de commande électronique du véhicule à moteur (10).

11. Dispositif électronique (11, 12) selon la revendication 9,
**caractérisé en ce que**
le dispositif électronique (11, 12) fait partie d'un système de capteurs du véhicule à moteur (10), en particulier, le dispositif électronique (11, 12) est une caméra automobile.

12. Véhicule à moteur (10) comprenant un dispositif électronique (11, 12) selon l'une des revendications 7 à 11.

13. Procédé de fabrication d'un dispositif électronique (11, 12), dans lequel le procédé comprend la fourniture d'au moins un circuit électronique (3, 4) pour le dispositif électronique (11, 12) et la fourniture d'un boîtier (1) avec une partie de boîtier (2), qui a une surface intérieure (9),
- un composant dissipateur de chaleur (5) est fourni et connecté à la surface intérieure (9) de la partie de boîtier (2), dans lequel le composant dissipateur de chaleur (5) comprend un matériau dont la conductivité thermique est supérieure à une conductivité thermique de la partie de boîtier (2) ;
- une région de contact du composant dissipateur de chaleur (5) est connectée à un composant électronique (4) du au moins un circuit électronique (3, 4), et
- le composant dissipateur de chaleur (5) est fabriqué à partir d'un matériau à structure en grille (7, 8).

14. Procédé selon la revendication 13,
**caractérisé en ce que**
- le composant dissipateur de chaleur (5) est connecté à la surface intérieure (9) de la partie de boîtier (2) au moyen d'un matériau adhésif et/ou au moyen d'au moins une fixation mécanique ; et/ou
- la région de contact est connectée au composant électronique (4) au moyen d'une pâte thermique (6).
